# EUROPEAN PATENT APPLICATION

(11) **EP 2 187 531 A1**
(43) Date of publication of application: **19.05.2010**
(21) Application number: 09704293.1
(22) Date of filing: 20.01.2009
(51) Int. Cl.: H04B 1/16, H04B 7/26, H04L 27/38

(54) **COMMUNICATION APPARATUS, COMMUNICATION SYSTEM, CONTROL METHOD AND CONTROL PROGRAM**

(30) Priority: 21.01.2008 JP 2008010451
(71) Applicant: Nec Corporation, Tokyo 108-8001 (JP)
(72) Inventor: MARUTA, Yasushi, Tokyo 108-8001 (JP)
(74) Representative: Glawe, Delfs, Moll
(86) International application number: PCT/JP2009/050780
(87) International publication number: WO 2009/093579

(57) **Abstract**

To provide a communication device in which an operation of demodulating a reception signal can be performed with good accuracy.

The communication device controls a parameter used when the reception signal is demodulated by a demodulation unit (104) according to an estimated frequency offset that is estimated from the reception signal and information obtained from the estimated frequency offset.

## Description

### [Technical field]

The present invention relates to a communication device such as a base station, a mobile terminal or the like, a communication system composed of these communication devices, a method for controlling a communication device, and a control program. In particular, the present invention relates to a communication device which can perform communication via a wireless transmission channel, a communication system, a control method, and a control program.

### [Background art]

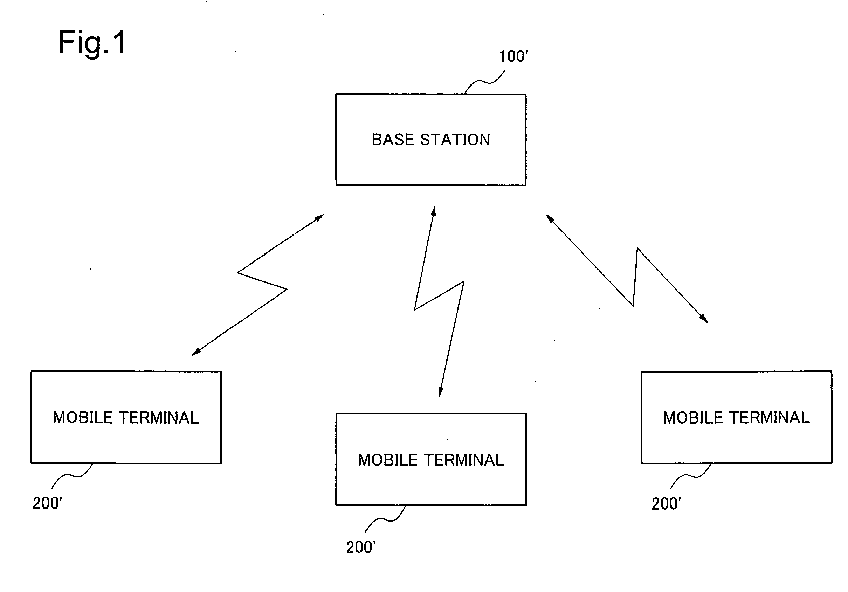

A base station 100 'and a mobile terminal 200' shown in Fig. 1 of which a general cellular mobile communication system is composed communicate with each other via the wireless transmission channel. The base station 100' communicates with the plurality of mobile terminals 200' by using a multiple access system such as a frequency division multiple access (FDMA) system, a time division multiple access (TDMA) system, a code division multiple access (CDMA) system, or the like.

When the base station 100' and the mobile terminal 200' communicate with each other via the wireless transmission channel, a frequency offset will exist in both a reception signal of the base station 100' and a reception signal of the mobile terminal 200'. The frequency offset is caused by, for example, a frequency shift between a frequency of the base station 100' and a frequency of the mobile terminal 200', a Doppler frequency which occurs when the mobile terminal 200' approaches or moves away from the base station 100' or the like.

Consequently, the base station 100' and the mobile terminal 200' have an AFC (Auto Frequency Control) circuit and perform an operation of correcting the frequency offset by the AFC. As a method for the frequency offset correction operation by the AFC, for example, a method with which a reception signal is demodulated, the frequency offset is estimated based on the demodulated signal and a frequency of a local transmitter is controlled based on the estimated frequency offset that is estimated and information obtained from the estimated frequency offset can be used. Additionally, a method with which a phase rotation processing is performed for each symbol of the reception signal according to the estimated frequency offset and the information obtained from the estimated frequency offset can be used.

Further, as a technical document of a patent application filed before the present invention, there is a technical document disclosing a technology with which a pull-in characteristic of an automatic frequency control is arbitrarily changed according to an angle of phase rotation generated by a frequency difference and whereby, the pull-in characteristic can be improved (for example, refer to patent document 1).

Additionally, there is a document that discloses a technology with which a frequency deviation compensation is realized for each multipath by performing a frequency deviation compensation to a received baseband signal (for example, refer to patent document 2).

Further, there is a document that discloses a technology with which channel estimation accuracy and transmission quality are certainly improved (for example, refer to patent document 3).

Further, there is a document that discloses a technology with which the frequency deviation can be detected with high accuracy (for example, refer to patent document 4).
[Patent document 1] Japanese Patent Application Laid-Open No. 2005-260438
[Patent document 2] Japanese Patent Application Laid-Open No. 2001-16120
[Patent document 3] Japanese Patent Application Laid-Open No. 2003-133998
[Patent document 4] Japanese Patent Application Laid-Open No. 2005-286759

### [Disclosure of invention]

### [Technical Problem]

However, the above-mentioned patent documents 1 and 2 do not contain a description of controlling a parameter used at the time of an operation of demodulating the reception signal and do not suggest a need for it For this reason, when the technology disclosed in the above-mentioned patent documents 1 and 2 is employed, the operation of demodulating the reception signal may not be performed with high accuracy.

Further, the above-mentioned patent documents 3 and 4 do not contain a description of controlling a parameter used at the time of the operation of demodulating the reception signal and do not suggest a need for it

The present invention has been invented in view of the above mentioned situation. The object of the present invention is to provide a communication device in which the operation of demodulating the reception signal can be performed with good accuracy that is the issue mentioned above, a communication system, a control method and a control program.

### [Technical Solution]

In order to achieve the object, the present invention is characterized as described below.

### <Communication device>

A communication device according to the present invention is **characterized in that** a parameter used when the reception signal is demodulated is controlled according to an estimated frequency offset that is estimated from the reception signal and information obtained from the estimated frequency offset

### <Communication system>

A communication system according to the present invention is composed of a plurality of communication devices. The communication device is **characterized in that** a parameter used when a reception signal is demodulated is controlled according to an estimated frequency offset that is estimated from the reception signal and information obtained from the estimated frequency offset.

### <Control method>

A control method according to the present invention is employed in a communication device. The communication device is characterized by performing a process in which the parameter used when the reception signal is demodulated is controlled according to the estimated frequency offset that is estimated from the reception signal and information obtained from the estimated frequency offset.

### <Control program>

A control program according to the present invention makes a communication device perform a process. The control program is **characterized in that** the program makes the communication device perform a process for controlling the parameter used when the reception signal is demodulated according to the estimated frequency offset that is estimated from the reception signal and information obtained from the estimated frequency offset.

### [Advantageous Effects]

By applying the present invention, the operation of demodulating the reception signal can be performed with good accuracy.

### [Best mode for carrying out the invention]

### <Outline of the communication system>

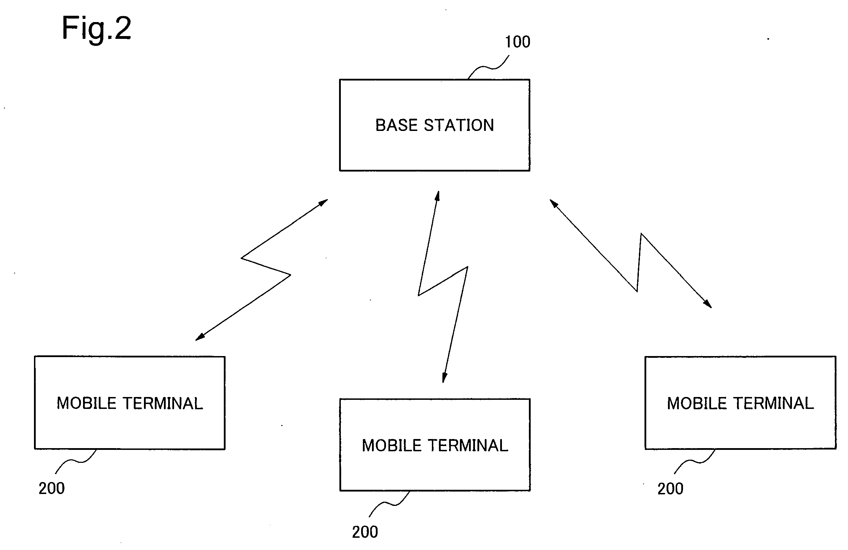

First, an outline of the communication system of this exemplary embodiment will be described with reference to Fig. 2.

A communication system of the exemplary embodiment is a communication system which is composed of a plurality of communication devices (that are a base station; 100 and a mobile terminal; 200). The communication devices 100 and 200 control the parameter used when the reception signal is demodulated according to the estimated frequency offset that is estimated from the reception signal and information obtained from the estimated frequency offset. As a result, the communication devices 100 and 200 can perform the operation of demodulating the reception signal with good accuracy. The communication system of this exemplary embodiment will be described in detail below with reference to the attached drawings.

### <Example of system configuration of the communication system>

First, an example of a system configuration of the communication system of the exemplary embodiment will be described with reference to Fig. 2.

The communication system of this exemplary embodiment is composed of a base station 100 and a mobile terminal 200.

The base station 100 and the mobile terminal 200 according to the exemplary embodiment communicate with each other via a wireless transmission channel. The base station 100 communicates with the plurality of mobile terminals 200 by using a multiple access system such as a frequency division multiple access (FDMA) system, a time division multiple access (TDMA) system, a code division multiple access (CDMA) system or the like.

### <Example of an internal configuration of a receiver installed in the base station; 100 and the mobile terminal; 200>

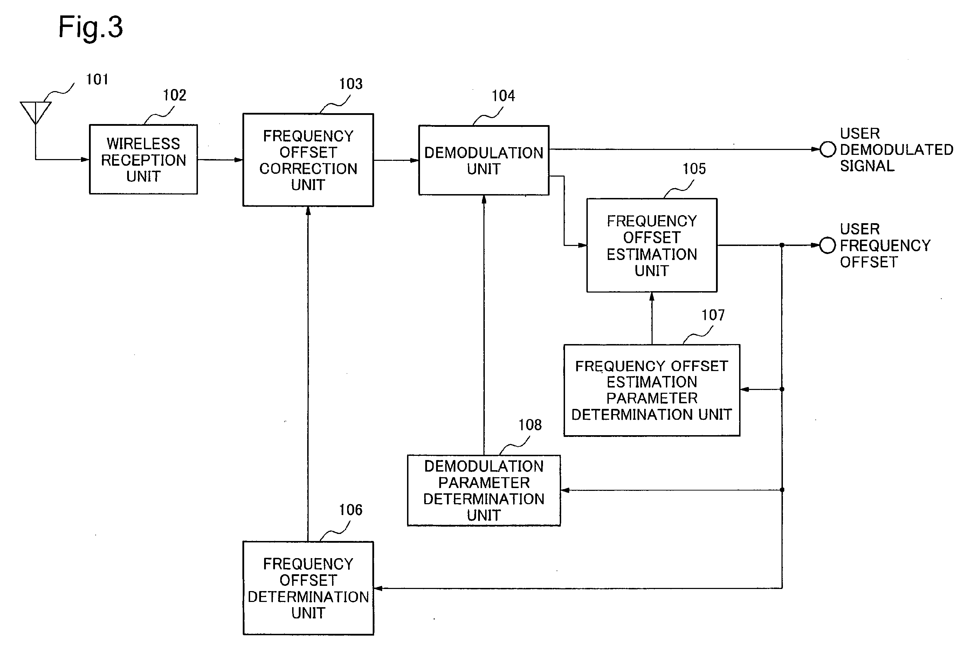

Next, an example of an internal configuration of a receiver installed in the base station 100 and the mobile terminal 200 of the exemplary embodiment will be described with reference to Fig. 3. The example of the internal configuration of the receiver of the base station 100 is approximately the same as that of the receiver of the mobile terminal 200. Therefore, hereinafter, in an explanation, both of the receivers are described as a receiver.

The receiver of the exemplary embodiment is composed of a reception antenna unit 101, a wireless reception unit 102, a frequency offset correction unit 103, a demodulation unit 104, a frequency offset estimation unit 105, a frequency offset determination unit 106, a frequency offset estimation parameter determination unit 107 and a demodulation parameter determination unit 108.

The reception antenna unit 101 receives a reception signal. A configuration of the reception antenna unit 101 of this exemplary embodiment is not limited in particular and various configurations can be used for the reception antenna unit 101. The number of the reception antenna elements of which the reception antenna unit 101 is composed and a method for arranging the reception antenna elements are not limited in particular and the reception antenna unit 101 can arbitrarily be configured.

The wireless reception unit 102 receives the reception signal received by the reception antenna unit 101. A configuration of the wireless reception unit 102 according to the exemplary embodiment is not limited in particular and various configurations can be used for the wireless reception unit 102. For example, the wireless reception unit 102 can be composed of a low noise amplifier, a band control filter, a mixer, a local transmitter, an AGC (Auto Gain Controller), a quadrature detector, a low pass filter, an analog-to-digital converter, and the like.

The reception signal received by the reception antenna unit 101 contains user signal components that have passed through a plurality of wireless transmission path channels, respectively and an interference signal component and a noise that are superimposed on the user signal components. Because the user signal component is transmitted via the plurality of wireless transmission path channels, the received user signal includes the plurality of user signal components whose amounts of delay are different from each other.

The wireless reception unit 102 performs a process such as amplification of the reception signal, a frequency conversion from a wireless band to a base band, a quadrature detection, an analog to digital conversion, and the like based on the reception signal received by the reception antenna unit 101 and outputs the processed signal to the frequency offset correction unit 103.

The frequency offset correction unit 103 corrects a frequency offset included in the reception signal c outputted by the wireless reception unit 102 based on the frequency offset outputted by the frequency offset determination unit 106 and outputs the corrected reception signal to the demodulation unit 104. Specifically, the frequency offset correction unit 103 will perform a phase rotation process corresponding to the frequency offset outputted by the frequency offset determination unit 106 to each symbol of the reception signal in the base band outputted by the wireless reception unit 102.

In the receiver shown in Fig. 3, the frequency offset correction unit 103 is arranged at a subsequent stage of the wireless reception unit 102. However, a function of the frequency offset correction unit 103 can be realized by controlling the frequency of the local transmitter in the wireless reception unit 102.

The demodulation unit 104 generates a demodulated signal based on the reception signal outputted by the frequency offset correction unit 103. As a demodulated signal generation method, the following methods can be used.

A method with which a specific user signal component is separated from a user signal component in which a plurality of user signals are multiplexed.
A method with which a detection and a selection of a timing, that is a path delay, of the multipath component of the specific user signal component are performed.
A method with which an estimation of a wireless transmission path channel is performed for each multipath component.
A method with which a combining of the multipath components is performed.

Further, the setting of the specific user signal component mentioned above can be arbitrarily changed. The method with which the specific user signal component is separated from the user signal component in which a plurality of user signals are multiplexed and the method with which the detection and the selection of the path delay is performed are not limited in particular and all methods can be applied. Further, the number of the path delays detected and the number of the path delays selected by the above-mentioned method are not limited in particular, and the arbitrary number of the path delays can be detected and the arbitrary number of the path delays can be selected.

As a path delay detection method, a method with which the detection of the path delay is performed by using the known symbol (pilot symbol or the like) of the specific user signal can be used. As a path delay selection method, a method with which the path delay satisfying a selection criterion is selected according to a predetermined selection criterion can be used.

As the above-mentioned selection criterion, the following selection criteria can be used.
The most significant M (M is an integer of 1 or more) path delays of the specific user signal components.
The most significant M (M is an integer of 1 or more) path delays of signal to interference power ratio (SIR) of the specific user signal.
The path delay of which the specific user signal component is greater than a threshold value.
The path delay of which the signal to interference power ratio of the specific user signal is greater than the threshold value.

The method with which the estimation of the wireless transmission path channel for each multipath component is performed is not limited in particular and all methods can be applied. As the method with which a wireless transmission path channel is estimated, a method with which the estimation of the wireless transmission path channel is performed by using the known symbol (pilot symbol or the like) of the specific user signal can be used.

The demodulation unit 104 generates the demodulated signal by using the method mentioned above. The demodulation unit 104 outputs the demodulated signal generated by using the above-mentioned method to a device provided at a subsequent stage of the receiver as a user demodulated signal. The demodulation unit 104 outputs the wireless transmission path channel estimation result that is estimated for each multipath component to the frequency offset estimation unit 105.

The frequency offset estimation unit 105 estimates the frequency offset of the reception signal based on the wireless transmission path channel estimation result for each multipath component that is outputted by the demodulation unit 104. The frequency offset estimation unit 105 outputs the estimated frequency offset that is estimated by using the above-mentioned method to the device provided at the subsequent stage of the receiver as a user frequency offset. The frequency offset estimation unit 105 outputs the estimated frequency offset to the frequency offset determination unit 106, the frequency offset estimation parameter determination unit 107 and the demodulation parameter determination unit 108.

The frequency offset estimation method used in the frequency offset estimation unit 105 is not limited in particular and all estimation methods can be applied. As the frequency offset estimation method, a method with which the wireless transmission path channel estimation result for each multipath component is weighted according to the precision of the estimation result, the combined wireless transmission path channel estimation result is generated, and an amount of phase rotation per unit time of the generated combined wireless transmission path channel estimation result is obtained can be used.

The following information can be used when a comparison of the precisions of the wireless transmission path channel estimation results for each multipath component is performed as the information for making a decision.

The signal to interference power ratio of the wireless transmission path channel estimation result for each multipath component.
A variance of the wireless transmission path channel estimation result for each multipath component

The frequency offset determination unit 106 determines the frequency offset that has to be actually corrected by the frequency offset correction unit 103 based on the estimated frequency offset that is estimated by the frequency offset estimation unit 105 and outputs the determined frequency offset to the frequency offset correction unit 103. As a result, the frequency offset correction unit 103 can correct the frequency offset included in the reception signal outputted by the wireless reception unit 102 based on the frequency offset determined by the frequency offset determination unit 106.

A frequency offset determination method used in the frequency offset determination unit 106 is not limited in particular and all determination methods can be applied. As the determination method, a method with which the following information that is obtained from the estimated frequency offset is used can be used.

An amount of the estimated frequency offset (the amount obtained by time average or moving average).
An amount of change per unit time of the estimated frequency offset.
A variance of the estimated frequency offset.

The frequency offset estimation parameter determination unit 107 determines a parameter used when the frequency offset is estimated by the frequency offset estimation unit 105 based on the estimated frequency offset that is estimated by the frequency offset estimation unit 105 and outputs the determined parameter to the frequency offset estimation unit 105. As a result, the frequency offset estimation unit 105 can estimate the frequency offset of the reception signal based on the parameter determined by the frequency offset estimation parameter determination unit 107.

A parameter determination method used in the estimation offset estimation parameter determination unit 107 is not limited in particular and all determination methods can be applied. The following information can be used as the parameter.

A sampling timing (cycle) of the wireless transmission path channel estimation result
A forgetting coefficient for obtaining the amount of the estimated frequency offset (the amount obtained by time average or moving average).

As the parameter determination method used when the frequency offset is estimated, a method with which the following information obtained from the estimated frequency offset is used can be used.

The amount of the estimated frequency offset (the amount obtained by time average or moving average).
The amount of change per unit time of the estimated frequency offset.
The variance of the estimated frequency offset.

The demodulation parameter determination unit 108 determines the parameter used at the time of the demodulation operation based on the estimated frequency offset that is estimated by the frequency offset estimation unit 105 and outputs the determined parameter to the demodulation unit 104. As a result, the demodulation unit 104 can generate the demodulated signal based on the parameter determined by the demodulation parameter determination unit 108.

The parameter determination method used in the demodulation parameter determination unit 108 is not limited in particular and all determination methods can be applied. The following information can be used as an example of the parameter.

A coefficient used when weighting a wireless transmission path channel estimation value for each unit time and combining them. The above-mentioned coefficient is used when the wireless transmission path channel for each multipath component is estimated by the demodulation unit 104.

As the parameter determination method, a method with which the following information obtained from the estimated frequency offset is used can be used.

The amount of the estimated frequency offset (the amount obtained by time average or moving average).
The amount of change per unit time of the estimated frequency offset.
The variance of the estimated frequency offset.

A moving status of the mobile terminal 200 excluding a fixed frequency shift between a frequency of the base station 100 and a frequency of the mobile terminal 200 can be inferred from information such as the amount of the estimated frequency offset (the amount obtained by time average or moving average), the amount of change per unit time of the estimated frequency offset, the variance of the estimated frequency offset, or the like. As specific examples, the following items can be used.

Whether the mobile terminal 200 approaches or moves away from the base station 100 within line-of-sight coverage from the base station 100.
A speed at which the mobile terminal 200 approaches or moves away from the base station 100 within line-of-sight coverage from the base station 100.
A distance between the mobile terminal 200 and the base station 100 within line-of-sight coverage from the base station 100.

The line-of-sight coverage from the base station 100 means an area in which there is no obstacle between the base station 100 and the mobile terminal 200. As a result, because a demodulation operation of the demodulation unit 104 can be optimized according to the moving status of the mobile terminal 200, the base station 100 can perform the operation of demodulating the reception signal with good accuracy. Additionally, even when the mobile terminal 200 is outside of the line-of-sight coverage from the base station 100, the operation of demodulating the reception signal can be performed with good accuracy by performing the similar demodulation operation on the assumption that the mobile terminal 200 is within line-of-sight coverage.

When information obtained from the estimated frequency offset that is used in the frequency offset determination unit 106, the frequency offset estimation parameter determination unit 107 and the demodulation parameter determination unit 108 is shared, these shared information are generated in the frequency offset estimation unit 105 in advance. A configuration in which the generated information is sent to the frequency offset determination unit 106, the frequency offset estimation parameter determination unit 107 and the demodulation parameter determination unit 108 can be used.

### <Function and effect of the exemplary embodiment>

As mentioned above, the receiver of the exemplary embodiment controls the parameter used at the time of the frequency offset estimation operation of the frequency offset estimation unit 105, at the time of the frequency offset correction operation of the frequency offset correction unit 103, and at the time of the demodulation operation of the demodulation unit 104 according to the estimated frequency offset that is estimated from the reception signal and information obtained from the estimated frequency offset. As a result, accuracy of the operation of demodulating the reception signal can be improved.

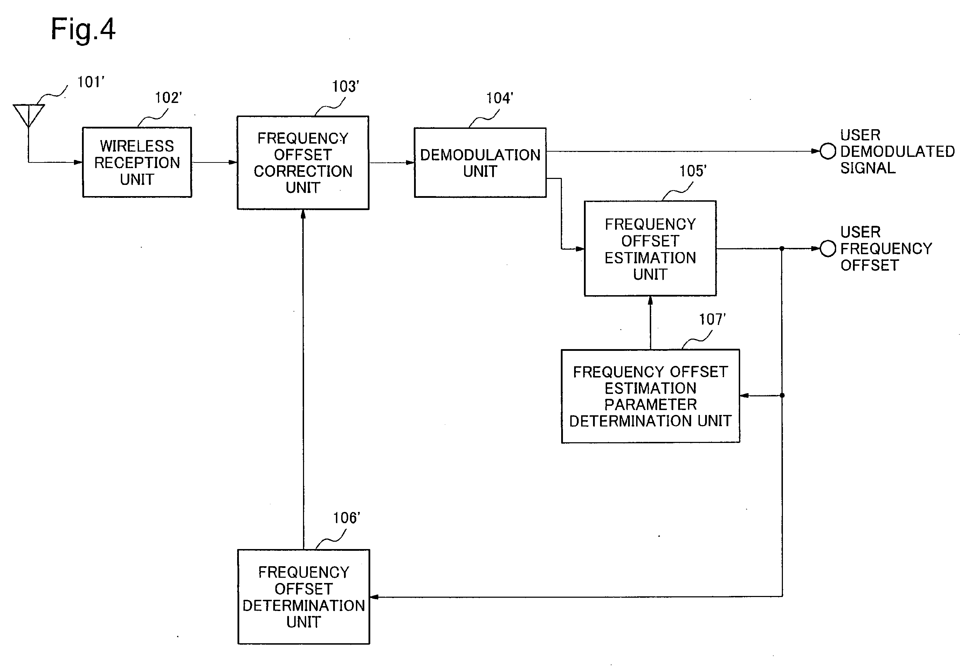

For example, the receiver disclosed in the above-mentioned patent documents 1 and 2 will have a configuration as shown in Fig. 4. Only the parameter used at the time of the frequency offset estimation operation of the frequency offset estimation unit 105' and at the time of the frequency offset correction operation of the frequency offset correction unit 103' is controlled according to the estimated frequency offset that is estimated from the reception signal and information obtained from the estimated frequency offset, and the parameter used at the time of the demodulation operation of the demodulation unit 104 is not controlled. For this reason, the operation of demodulating the reception signal cannot be performed with good accuracy.

In contrast, as shown in Fig. 3, the receiver of the exemplary embodiment controls the parameter used at the time of the demodulation operation of the demodulation unit 104. Therefore, accuracy of the operation of demodulating the reception signal can be improved.

Further, the exemplary embodiment described above is the preferred exemplary embodiment of the present invention. The scope of the present invention is not limited to only the above-mentioned exemplary embodiment, and variations of the present invention are possible without departing from the scope of the present invention.

For example, the communication system of this exemplary embodiment is not limited to a communication system using the multiple access system and can be applied to a communication system using any type of communication system.

The control operation of each of the devices of which the communication system of this exemplary embodiment mentioned above is composed can be carried out by using hardware, software or a composite configuration formed by both hardware and software.

Further, when the process is performed by using software, the process can be performed by installing a program in which a processing sequence is recorded in a memory in a computer incorporated in dedicated hardware and executing the program. Alternatively, the process can be performed by installing the program in a general-purpose computer which can carry out the various processes and executing the program.

For example, the program can be recorded in a hard disk or a ROM (Read Only Memory) that is a recording medium in advance. Alternatively, the program can be stored (recorded) in a removable recording medium temporarily or permanently. Such removable recording medium can be supplied as so-called packaged software. Further, the removable recording medium such as a floppy (the registered trademark) disk, a CD-ROM (Compact Disc Read Only Memory), a MO (Magneto optical) disk, a DVD (Digital Versatile Disc), a magnetic disk, a semiconductor memory, or the like can be used.

Further, the program is installed in the computer from the removable recording medium mentioned above. Alternatively, the program is transferred to the computer from a download site by wireless transmission. Otherwise, the program is transferred to the computer by wire via a network.

The communication system of the exemplary embodiment time-sequentially performs the process according to the processing operation described in the above exemplary embodiment. Further, the communication system can be configured so that the process is performed in parallel or individually depending on processing capacity of the device that performs the process or necessity.

Further, this application claims priority based on Japanese patent application No. 2008 - 010451, filed January 21, 2008 and the disclosure of which is hereby incorporated.

### [Industrial applicability]

The present invention can be applied to a reception unit of a communication device such as a base station, a mobile terminal, and the like of which the cellular mobile communication system is composed.

### [Brief description of drawings]

[Figure. 1] Fig. 1 shows an example of a system configuration of a communication system related to the present invention.
[Figure. 2] Fig. 2 shows an example of a system configuration of a communication system of the exemplary embodiment
[Figure. 3] Fig. 3 shows an example of an internal configuration of a receiver installed in a base station, a mobile terminal, and the like of which a communication system of the exemplary embodiment is composed.
[Figure. 4] Fig. 4 shows an example of an internal configuration of a receiver related to the present invention.

### [Explanation of Reference]

- 100: base station
- 200: mobile terminal
- 101: reception antenna unit
- 102: wireless reception unit
- 103: frequency offset correction unit
- 104: demodulation unit
- 105: frequency offset estimation unit
- 106: frequency offset determination unit
- 107: frequency offset estimation parameter determination unit
- 108: demodulation parameter determination unit

## Claims

1. A communication device **characterized in that** a parameter used when a reception signal is demodulated is controlled according to an estimated frequency offset that is estimated from the reception signal and information obtained from the estimated frequency offset.

2. The communication device according to claim 1 **characterized in that** a parameter used when the frequency offset is estimated and a parameter used when the frequency offset is corrected are controlled according to said estimated frequency offset and information obtained from the estimated frequency offset.

3. The communication device according to any one of claims 1 and 2 **characterized by** comprising:
demodulation means for demodulating the reception signal and generating a demodulated signal;
frequency offset estimation means for estimating the frequency offset based on the demodulated signal; and
demodulation parameter determination means for controlling the parameter used at the time of a demodulation operation of the demodulation means according to the estimated frequency offset that is estimated by the frequency offset estimation means and information obtained from the estimated frequency offset.

4. The communication device according to claim 3 **characterized by** comprising:
frequency offset correction means for correcting the frequency offset of the reception signal and outputting the corrected reception signal to the demodulation means;
frequency offset estimation parameter determination means for controlling a parameter used at the time of an offset estimation operation of the frequency offset estimation means according to the estimated frequency offset that is estimated by the frequency offset estimation means and information obtained from the estimated frequency offset; and
frequency offset determination means for controlling a parameter used at the time of an offset correction operation of the frequency offset correction means according to the estimated frequency offset that is estimated by the frequency offset estimation means and information obtained from the estimated frequency offset.

5. The communication device according to claim 4 **characterized in that** when information obtained from the estimated frequency offsets that are used in the demodulation parameter determination means, the frequency offset estimation parameter determination means, and the frequency offset determination means are shared, the information obtained from the estimated frequency offset is generated by the frequency offset estimation means.

6. A communication system which is composed of a plurality of communication devices **characterized in that**
the communication device controls a parameter used when a reception signal is demodulated according to an estimated frequency offset that is estimated from the reception signal and information obtained from the estimated frequency offset.

7. A control method performed in a communication device **characterized in that**
the communication device performs a process in which a parameter used when a reception signal is demodulated is controlled according to an estimated frequency offset that is estimated from the reception signal and information obtained from the estimated frequency offset.

8. A control program which makes a communication device perform a process **characterized in that** the program makes the communication device perform a process for controlling a parameter used when a reception signal is demodulated according to an estimated frequency offset that is estimated from the reception signal and information obtained from the estimated frequency offset.
